# EUROPEAN PATENT APPLICATION

(11) **EP 4 679 686 A1**
(43) Date of publication of application: **14.01.2026**
(21) Application number: 23926155.5
(22) Date of filing: 03.03.2023
(51) Int. Cl.: H02K 15/02

(54) **INSPECTION DEVICE FOR ROTARY ELECTRIC MACHINE, INSPECTION SYSTEM FOR ROTARY ELECTRIC MACHINE, AND INSPECTION METHOD FOR ROTARY ELECTRIC MACHINE**

(71) Applicant: Mitsubishi Generator Co., Ltd., Kobe City, Hyogo 652-8555 (JP)
(72) Inventor: MATSUMOTO, Hibiki, Tokyo 100-8310 (JP); DINH, Duyanh, Tokyo 100-8310 (JP); HATTORI, Yasuki, Tokyo 100-8310 (JP); FUKUSHIMA, Kazuhiko, Tokyo 100-8310 (JP); MORIMOTO, Yoshihiro, Tokyo 100-8310 (JP)
(74) Representative: Witte, Weller & Partner Patentanwälte mbB
(86) International application number: PCT/JP2023/007968
(87) International publication number: WO 2024/184939

(57) **Abstract**

An inspection device (50) for a rotary electric machine including a rotor (1) provided around a shaft (3) and rotor retaining rings (2) fixed on both end sides in an axial direction of the rotor (1) includes: base units (10) respectively attached to the rotor retaining rings (2), using first fastening members (11); guide wires (13) stretched between the base units (10); an inspection robot (16) of which both side portions are restricted by the guide wires (13); a driving wire (17) which is attached to the inspection robot (16) and moves the inspection robot (16) in the axial direction; and second fastening members (19) provided to the base units (10) and fixing the respective base units (10) to the shaft (3) on axial-direction outer sides relative to the first fastening members (11).

## Description

### TECHNICAL FIELD

The present disclosure relates to an inspection device for a rotary electric machine, an inspection system for a rotary electric machine, and an inspection method for a rotary electric machine.

### BACKGROUND ART

In order to efficiently inspect a cylindrical object such as a rotary electric machine, an inspection robot that is attached to a cylinder part and moves in the axial direction is useful. Conventionally, a robot that is attached to a rotary electric machine by using a magnetic force and travels by wheels or crawlers with a driving source has been proposed. However, there are problems that it is difficult to perform movement in the circumferential direction of the cylinder and the size of the robot is increased due to provision of components for driving in the axial direction. For solving these problems, such a configuration that movements in the axial direction and the circumferential direction of the robot are performed by a device other than a robot, is being considered.

One of inspection devices for a rotary electric machine is composed of a detection probe which moves through a gap between a stator and a rotor of the rotary electric machine, and a base unit for assisting movement of the detection probe (see, for example, Patent Document 1). The detection probe travels in the axial direction of the rotor through the gap between the stator and the rotor by a pulling cable and a support cable attached to the base unit, and the base unit moves in the circumferential direction on a rotor cap, whereby the detection probe can inspect the inside of the rotary electric machine thoroughly.

### CITATION LIST

### PATENT DOCUMENT

Patent Document 1: Japanese Laid-Open Patent Publication No. 2002-262522
Patent Document 2: Japanese Laid-Open Patent Publication No. 3-261351

### SUMMARY OF THE INVENTION

### PROBLEM TO BE SOLVED BY THE INVENTION

In the conventional inspection device for the rotary electric machine, a movement function in the axial direction and the circumferential direction of the rotary electric machine is imparted to the base unit provided on the rotor cap, whereby size reduction and weight reduction of a device that enters the inside of the rotary electric machine can be achieved. However, when a tension is applied to the support cable, the base unit tilts toward the center side of the rotary electric machine around a circumferential-direction rotation wheel as a rotation center, so that the posture becomes unstable. In this regard, in Patent Document 1, the posture is stabilized using a belt for fixing the base unit to the rotary electric machine and a stopper provided at an end. However, in a case of applying a great tension to the support cable for a reason such as enhancing advancement straightness of an inspection probe, a rotational moment generated on the base unit cannot be suppressed by only the stopper provided at the end and the belt having an arm with a small moment about the rotation center as in Patent Document 1.

Patent Document 2 discloses a structure in which a tension applied to a guide portion is received by a tension reception portion hooked at an end of a rotary electric machine. However, a part for hooking is needed and therefore the structure cannot be applied without the part for hooking.

The present disclosure has been made to solve the above problems, and an object of the present disclosure is to provide an inspection device for a rotary electric machine, an inspection system for a rotary electric machine, and an inspection method for a rotary electric machine that enable a base unit to maintain a stable posture even when a tension is applied to a cable or the like for restricting the posture of an inspection robot, and can shorten a time for inspection without reducing inspection accuracy.

### MEANS TO SOLVE THE PROBLEM

An inspection device for a rotary electric machine according to the present disclosure is an inspection device for a rotary electric machine including a rotor provided around a shaft and rotor retaining rings fixed on both end sides in an axial direction of the rotor, the inspection device including: base units respectively attached to the rotor retaining rings, using first fastening members; guide wires stretched between the base units; an inspection robot of which both side portions in a circumferential direction are restricted by the guide wires; a driving wire which is attached to the inspection robot and moves the inspection robot in the axial direction; and second fastening members provided to the base units and fixing the respective base units to the shaft on axial-direction outer sides relative to the first fastening members.

### EFFECT OF THE INVENTION

According to the present disclosure, it becomes possible to provide an inspection device for a rotary electric machine, an inspection system for a rotary electric machine, and an inspection method for a rotary electric machine that enable a base unit to maintain a stable posture even when a tension is applied to a cable or the like for restricting the posture of an inspection robot, and can shorten a time for inspection without reducing inspection accuracy.

### BRIEF DESCRIPTION OF THE DRAWINGS

[FIG. 1] FIG. 1 is a side view showing a configuration of an inspection device for a rotary electric machine according to embodiment 1.
[FIG. 2] FIG. 2 is a plan view showing a configuration of the inspection device for the rotary electric machine according to embodiment 1.
[FIG. 3] FIG. 3 is partial sectional views schematically showing a configuration of the inspection device for the rotary electric machine according to embodiment 1, where FIG. 3A is a schematic view illustrating components attached to a base unit and FIG. 3B is a schematic view illustrating a state in which the base unit is attached to a rotor retaining ring as seen in an arrow P-P direction in FIG. 1.
[FIG. 4] FIG. 4 shows a configuration of the inspection device for the rotary electric machine according to embodiment 1 as seen in the axial direction and in an arrow Q direction in FIG. 1.
[FIG. 5] FIG. 5 illustrates definitions of directions about the rotary electric machine.
[FIG. 6] FIG. 6 shows a configuration of a rotation prevention fastening member provided to the inspection device for the rotary electric machine according to embodiment 1, where FIG. 6A is a view as seen from the side surface side of the rotary electric machine and FIG. 6B is a view as seen in the axial direction.
[FIG. 7] FIG. 7 illustrates a state in which the rotation prevention fastening member provided to the inspection device of the rotary electric machine according to embodiment 1 is fastened.
[FIG. 8] FIG. 8A illustrates movement of the base unit when a tension is applied to a guide wire in a case of not providing the rotation prevention fastening member as a comparative example, and FIG. 8B illustrates another movement of the base unit.
[FIG. 9] FIG. 9 illustrates an effect of the rotation prevention fastening member according to embodiment 1.
[FIG. 10] FIG. 10 shows a configuration of a rotation prevention fastening member provided to an inspection device of a rotary electric machine according to embodiment 2, where FIG. 10A is a view as seen from the side surface side of the rotary electric machine and FIG. 10B is a view as seen in the axial direction.
[FIG. 11] FIG. 11 shows a configuration of a driving unit provided to an inspection device for a rotary electric machine according to embodiment 3, where FIG. 11A is a view as seen from the side surface side of the rotary electric machine and in an arrow A direction in FIG. 11C, FIG. 11B is a view as seen in an arrow B-B direction in FIG. 11C, and FIG. 11C is a plan view.
[FIG. 12] FIG. 12A shows the position of a driving wire in a case where a driving unit provided with no position adjustment mechanism operates as a comparative example, and FIG. 12B shows the position of a driving wire in a case where the driving wire is driven directly by a winding winch as a comparative example.
[FIG. 13] FIG. 13 illustrates the position of a driving wire in a case of using the driving unit according to embodiment 3.
[FIG. 14] FIG. 14 illustrates an inspection device for a rotary electric machine according to embodiment 4 and shows an example in which the inspection device for a rotary electric machine according to any of embodiments 1 to 3 is placed in the rotary electric machine.
[FIG. 15] FIG. 15 shows a configuration example of an inspection system for a rotary electric machine according to embodiment 4.
[FIG. 16] FIG. 16 is a flowchart showing an example of an inspection method for a rotary electric machine using the inspection system for the rotary electric machine according to embodiment 4.
[FIG. 17] FIG. 17 is a hardware configuration diagram showing an example of a control unit of the inspection system shown in FIG. 15.

### DESCRIPTION OF EMBODIMENTS

### Embodiment 1

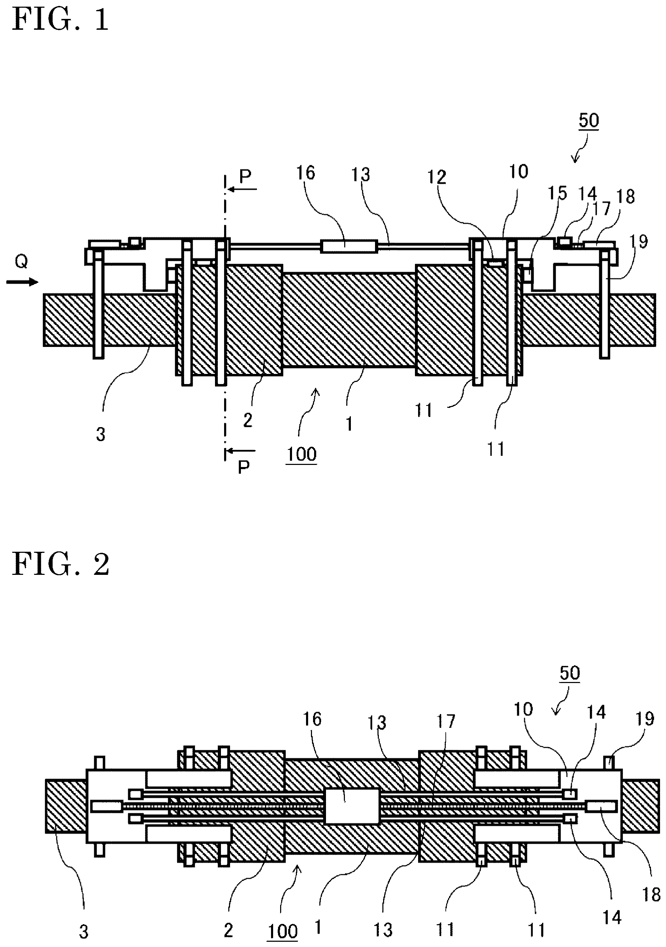

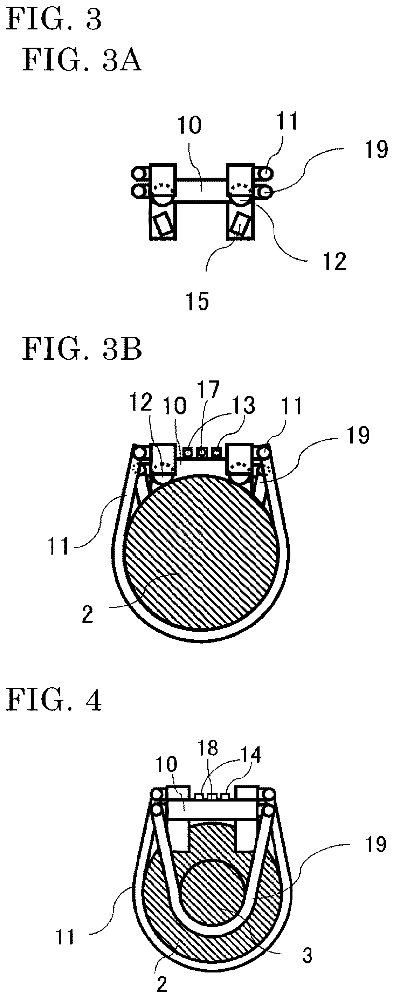

FIG. 1 is a side view showing a configuration of an inspection device for a rotary electric machine according to embodiment 1, and FIG. 2 is a plan view thereof. FIG. 3 is a partial sectional view schematically showing a configuration of the inspection device for the rotary electric machine as seen in the axial direction, where FIG. 3A is a schematic view around a base unit and illustrates components attached to the base unit, and FIG. 3B is a schematic view showing a state in which the base unit is attached to a rotor retaining ring as seen in arrow P-P direction in FIG. 1. FIG. 4 shows a configuration of the inspection device for the rotary electric machine as seen in an arrow Q direction in FIG. 1 and in the axial direction.

In the drawings, an inspection device 50 includes base units 10, fastening members 11, circumferential-direction rotation wheels 12, guide wires 13, guide wire tension generation devices 14, contact wheels 15, an inspection robot 16, driving wires 17, driving units 18, and rotation prevention fastening members 19. The inspection device 50 is attached to a rotary electric machine 100 including a cylindrical rotor 1 provided around a shaft 3 and rotor retaining rings 2 fixed on both end sides of the rotor 1, and inspects the rotary electric machine. The rotor 1 rotates with rotation of the shaft 3.

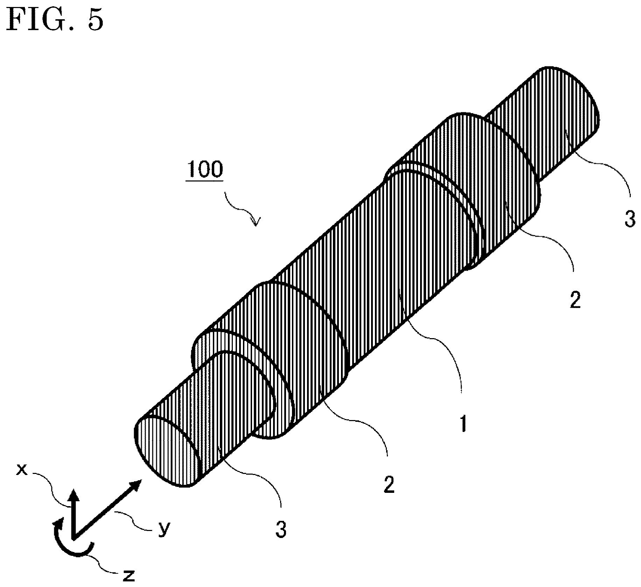

Here, directions about the rotary electric machine will be described with reference to FIG. 5. In FIG. 5, a direction along the radius of the cylinder shape of the rotary electric machine is defined as a radial direction (x direction), a direction along the axis of the cylinder shape of the rotary electric machine is defined as an axial direction (y direction), and a direction along the circumference of the cylinder shape of the rotary electric machine is defined as a circumferential direction (z direction).

### <Configurations of parts of inspection device 50>

The base unit 10 is a frame which serves as a base of a structure of the inspection device 50 and on which components are mounted. The inspection device 50 includes two base units 10 which are provided so as to be opposed to each other at the rotor retaining rings 2 attached on both end sides of the rotor 1.

The fastening member 11 is a component for fastening the base unit 10 to the rotor retaining ring 2. The base unit 10 is fastened by one or a plurality of fastening members 11, whereby the posture of the base unit 10 is stabilized. The fastening member 11 is wound around the rotor retaining ring 2 as shown in FIG. 4, for example, whereby the base unit 10 is fastened to the rotor retaining ring 2.

The circumferential-direction rotation wheels 12 are provided to the base unit 10 and contact with the rotor retaining ring 2 in the circumferential direction, as shown in FIG. 1 and FIG. 3B. The circumferential-direction rotation wheels 12 serve as traveling wheels when the inspection device 50 travels on the surface of the rotor retaining ring 2 in the circumferential direction (z direction) of the rotary electric machine. The circumferential-direction rotation wheels 12 are provided with a motor and a brake for stopping (which are not shown). The motor serves to travel in the circumferential direction (z direction) of the rotary electric machine, and the brake serves to stop movement in the circumferential direction.

The guide wires 13 are wires stretched between two base units 10. When tensions are applied by the guide wire tension generation devices 14, the guide wires 13 are subjected to forces in directions to pull the two base units 10 close to each other. The positions in the radial direction (x direction) of the guide wires 13 can be changed by the guide wire tension generation devices 14. The inspection robot 16 is attached to the guide wires 13. For example, two guide wires 13 pass through both ends in the circumferential direction of a frame of the inspection robot 16, whereby both side portions of the inspection robot 16 are restricted and the inspection robot 16 can be moved in the axial direction (y direction) along the guide wires 13. At this time, as the tensions applied to the guide wires 13 become greater, the guide wires 13 become more rigid and the positions thereof are less displaced by forces received from the inspection robot 16, so that advancement straightness of the inspection robot 16 is enhanced.

The contact wheels 15 are mounted to the base unit 10 and contact with the axial-direction end of the rotor retaining ring 2. When the guide wires 13 are subjected to tensions so that forces are applied in directions to pull the two base unit 10 close to each other, the contact wheels 15 are pressed against the rotor retaining rings 2, thereby positioning the two base units 10 in the axial direction (y direction). In addition, when the base unit 10 travels in the circumferential direction on the surface of the rotor retaining ring 2, the contact wheels 15 serve as traveling wheels to travel on the axial-direction end of the rotor retaining ring 2.

In the inspection robot 16, through holes for attachment to the guide wires 13 are provided to a frame for holding an inspection probe, for example, and the direction in which the inspection robot 16 can move is determined by the guide wires 13 passing through the through holes. Ends of the driving wires 17 are attached to both axial-direction ends of the inspection robot 16. The driving wires 17 extending in the axial direction from the two base units 10 are driven by the driving units 18, whereby the inspection robot 16 is moved in the axial direction (y direction). Instead of passing through the inspection robot 16, the guide wires 13 may be attached to both axial-direction ends of the inspection robot 16, as with the driving wires 17, as long as the posture of the inspection robot 16 can be restricted.

### <Configuration of rotation prevention fastening member 19>

The rotation prevention fastening member 19 is a second fastening member provided separately from the fastening members 11, and is attached to each base unit 10 on the outer side, i.e., the end side, in the axial direction of the rotary electric machine relative to the position where the fastening members 11 are provided, as shown in FIG. 1 and FIG. 2. The above side is opposite to the center side of the rotary electric machine. As shown in FIG. 4, the rotation prevention fastening member 19 is wound around the shaft 3, whereby the base unit 10 is fastened to the shaft 3. The rotation prevention fastening member 19 is adjusted in such a state that the rotation prevention fastening member 19 has no tension or a slight tension when the posture of the base unit 10 is kept horizontal relative to the axial direction. The length of the rotation prevention fastening member 19 is set so that a tension is generated when the base unit 10 rotates in a direction to move away from the shaft 3 around the circumferential-direction rotation wheels 12 or the contact wheels 15 as a rotation center.

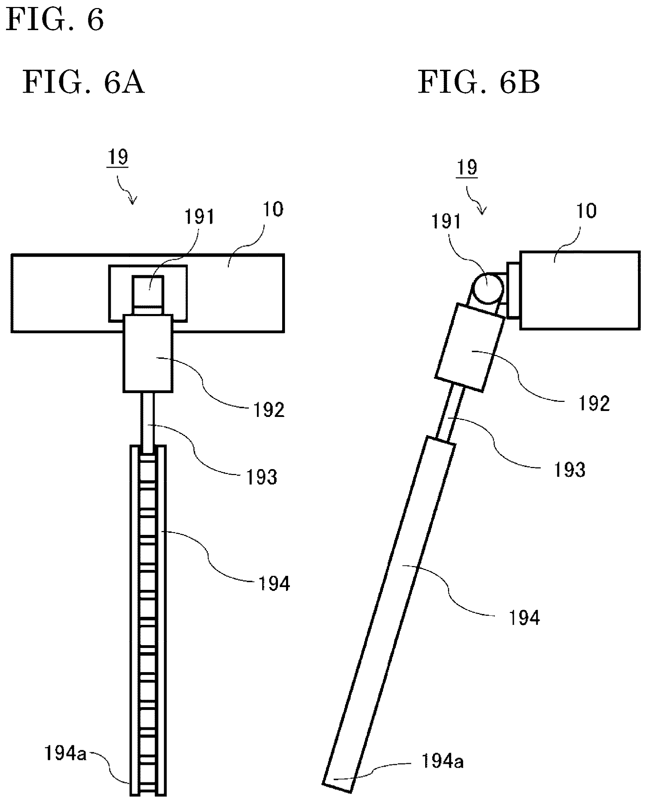

FIG. 6 shows a detailed configuration of the rotation prevention fastening member 19, where FIG. 6A is a view as seen from the side surface side of the rotary electric machine, and FIG. 6B shows a state before fastening as seen in the axial direction of the rotary electric machine. The rotation prevention fastening member 19 includes a rotation link 191, a tension adjustment mechanism 192, a connection member 193, and a chain 194.

The rotation link 191 is attached to a circumferential-direction end of the base unit 10. The rotation link 191 serves to connect the tension adjustment mechanism 192, and provides a degree of freedom in rotation to the tension adjustment mechanism 192, the connection member 193, and the chain 194. The tension adjustment mechanism 192 is a mechanism for adjusting the tension of the chain 194. For example, a mechanism for adjusting the tension by changing the length of a turn buckle or the like is used. The connection member 193 serves to connect the tension adjustment mechanism 192 and the chain 194 and has a mechanism to which an end 194a of the chain 194 or the like is attached, thus facilitating attachment/detachment of the chain. As shown in FIG. 4, the chain 194 is fastened by being wound around the shaft 3, and the tension thereof is adjusted by the tension adjustment mechanism 192.

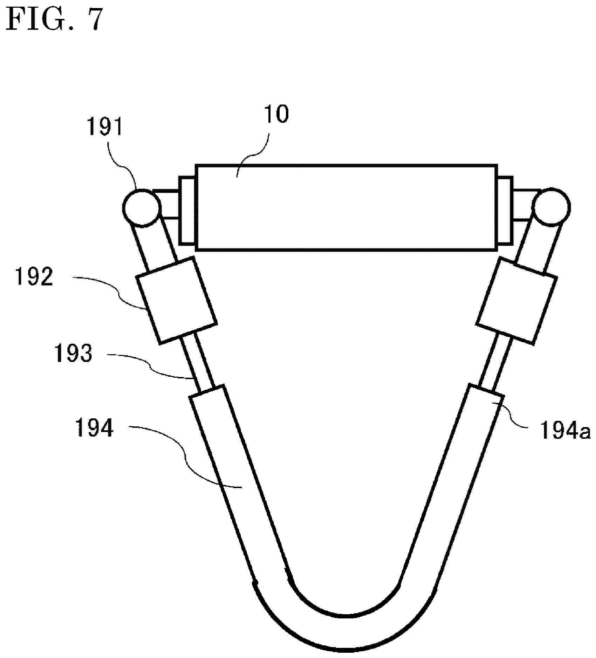

FIG. 7 shows a state in which the chain 194 shown in FIG. 6B is fastened, with the rotary electric machine not shown. The end 194a of the chain shown in FIG. 6B is attached to the connection member 193 connected to the tension adjustment mechanism 192 and the rotation link 191 attached to an end on the opposite side in the circumferential direction of the base unit 10, whereby the base unit 10 is fixed to the shaft 3 by the chain 194.

Next, effects of the rotation prevention fastening member 19 will be described.

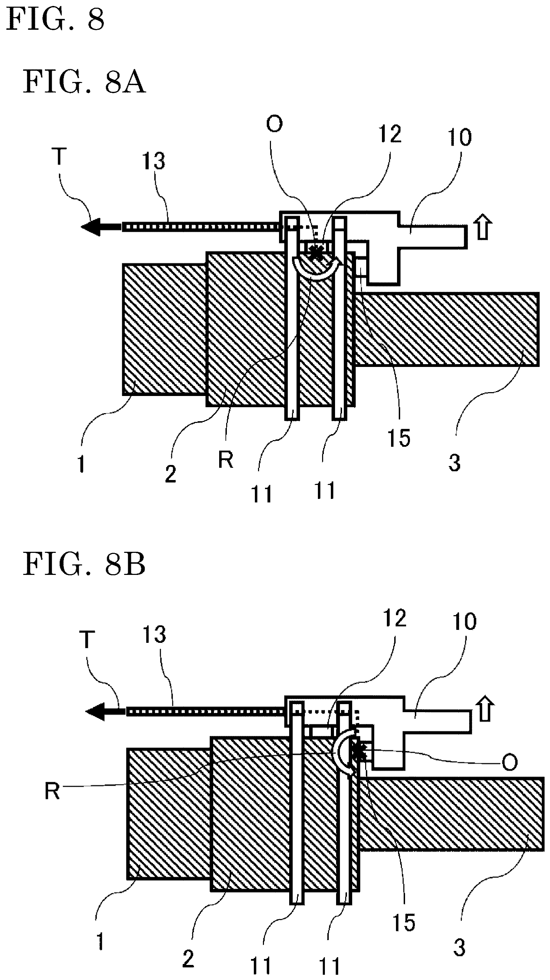

First, as a comparative example, FIG. 8 shows change in the posture of the base unit 10 in a case where a tension is applied to the guide wire 13 in a state in which the rotation prevention fastening member 19 is not provided.

In FIG. 8A, when a tension T is applied to the guide wire 13, the base unit 10 moves in the axial direction (y direction) until the contact wheel 15 comes into contact with the end of the rotor retaining ring 2. When the contact wheel 15 comes into contact with the end of the rotor retaining ring 2, as shown in FIG. 8A, a rotational moment R is generated on the base unit 10 around a contact point between the circumferential-direction rotation wheel 12 and the rotor retaining ring 2 as a rotation center O, so that the posture of the base unit 10 becomes unstable, or as shown in FIG. 8B, a rotational moment R is generated on the base unit 10 around a contact point between the contact wheel 15 and the rotor retaining ring 2 as a rotation center O, so that the posture of the base unit 10 becomes unstable. In either case, a force is applied in a direction (see a blank arrow) in which the axial-direction outer side of the base unit 10 moves away from the shaft. This influences the posture of the inspection robot 16, so that inspection accuracy might be reduced.

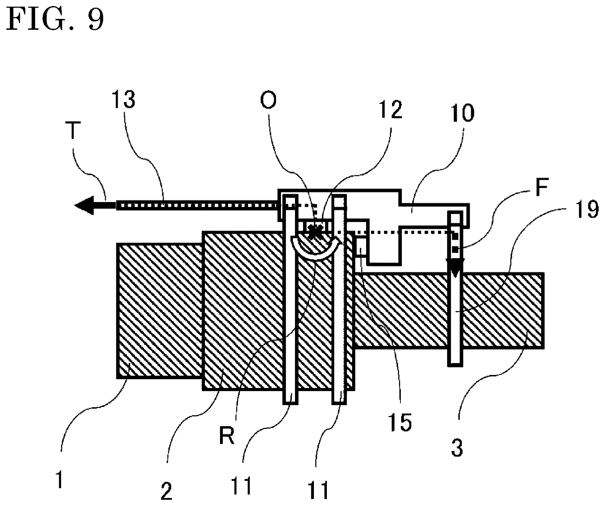

FIG. 9 shows a state in which a tension T is applied to the guide wire 13 in the inspection device 50 including the rotation prevention fastening member 19 according to the present embodiment 1. When the tension T is applied to the guide wire 13, the base unit 10 moves in the axial direction until the contact wheel 15 comes into contact with the end of the rotor retaining ring 2. When the contact wheel 15 comes into contact with the end of the rotor retaining ring 2, a rotational moment R is generated on the base unit 10 around a contact point between the circumferential-direction rotation wheel 12 and the rotor retaining ring 2 as a rotation center O, so that the posture of the base unit 10 changes and the base unit 10 attempts to move away from the shaft 3 in the radial direction. At this time, a tension is generated in the rotation prevention fastening member 19, so that a force F is generated toward the radial-direction center of the rotary electric machine, whereby the rotational moment R can be canceled out. Thus, the posture of the base unit 10 can be maintained.

Similarly, after the tension T is applied to the guide wire 13, also in a case where a rotational moment is generated on the base unit 10 around a contact point between the contact wheel 15 and the rotor retaining ring 2 as a rotation center, the base unit 10 attempts to move away from the shaft 3 in the radial direction of the rotary electric machine, and at the same time, a tension is generated on the rotation prevention fastening member 19. Thus, a force is generated toward the radial-direction center of the rotary electric machine, whereby the rotational moment R can be canceled out and the posture of the base unit 10 can be maintained.

The rotation prevention fastening member 19 may be provided at any position as long as a rotational moment generated on the base unit 10 when a tension is applied to the guide wire 13 can be canceled out. As the chain 194, a member other than a chain may be used as long as the member can be wound around the shaft 3. For example, a string-shaped or band-shaped member such as a cable, a rope, or a belt may be used.

As described above, the inspection device for the rotary electric machine according to embodiment 1 includes: the base units 10 respectively attached to the rotor retaining rings 2, using the fastening members 11 (first fastening members); the guide wires 13 stretched between the two base units 10; the inspection robot 16 of which both side surfaces are restricted by the guide wires 13; the driving wire 17 which is attached to the inspection robot 16 and moves the inspection robot 16 in the axial direction; and the rotation prevention fastening members 19 (second fastening members) provided to the base units 10 and fixing the respective base units 10 to the shaft 3 on the axial-direction (y-direction) outer sides relative to the first fastening members. Therefore, by the rotation prevention fastening member 19, a rotational moment on the base unit 10 around the circumferential-direction rotation wheels 12 as a rotation center, which is generated when a tension is applied to the guide wire 13, can be canceled out. Thus, an effect of stabilizing the posture of the base unit 10 is provided. Since the posture of the base unit 10 is stabilized, it becomes possible to apply a great tension to the guide wire 13, whereby the guide wire 13 can be fixed in a rigid state, so that advancement straightness of the inspection robot 16 can be enhanced when the inspection robot 16 is driven in the axial direction (y direction) of the rotary electric machine.

Each rotation prevention fastening member 19 (second fastening member) includes the chain 194 wound around the shaft 3, the tension adjustment mechanism 192 which adjusts a tension of the chain, the rotation link 191 connecting the base unit 10 and the tension adjustment mechanism 192, and the connection member connecting the chain 194 and the tension adjustment mechanism 192. Thus, an effect of allowing the length of the rotation prevention fastening member 19 and a generated tension to be freely adjusted is provided.

The rotor 1 of the rotary electric machine has the shaft 3 on the axial-direction outer side of the rotor retaining ring 2, and the rotation prevention fastening members 19 can be attached irrespective of the shapes of the rotor retaining rings 2. Thus, using the rotation prevention fastening member 19 according to the present embodiment can provide an effect of suppressing rotation of the base unit 10 irrespective of the shape of the rotary electric machine.

### Embodiment 2

Hereinafter, an inspection device for a rotary electric machine according to embodiment 2 will be described with reference to the drawings. A configuration of the rotation prevention fastening member 19 is different from that in embodiment 1. The other configurations are the same as in embodiment 1.

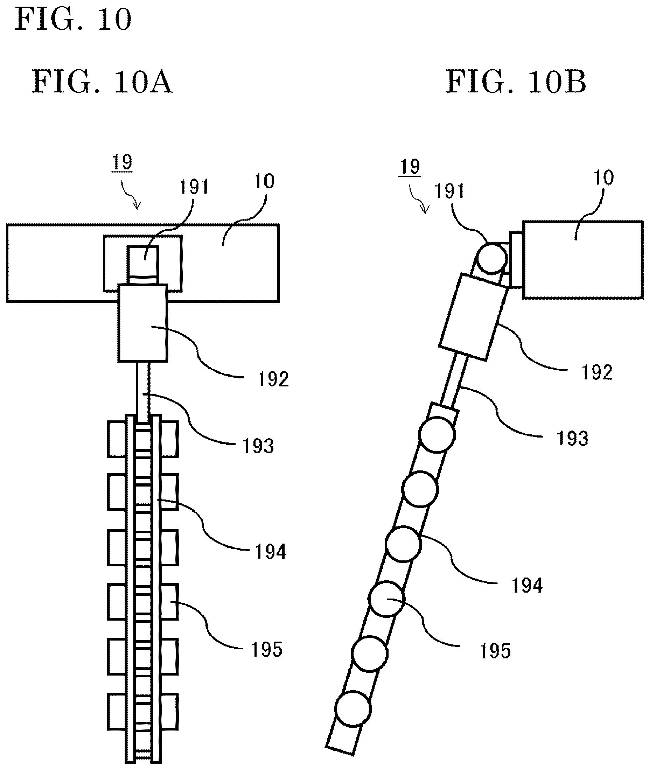

FIG. 10 shows a configuration of the rotation prevention fastening member 19 according to embodiment 2. FIG. 10A is a view as seen from the side surface side of the rotary electric machine, and FIG. 10B shows a state before fastening as seen in the axial direction of the rotary electric machine. The rotation prevention fastening member 19 includes the rotation link 191, the tension adjustment mechanism 192, the connection member 193, the chain 194, and rolling elements 195. Regarding the rotation link 191, the tension adjustment mechanism 192, the connection member 193, and the chain 194 other than the rolling elements 195, functions, operations, and the like are the same as those described in embodiment 1, and the description thereof is omitted.

The rolling elements 195 are attached to the chain 194, and when the chain 194 is wound around the shaft 3, the rolling elements 195, instead of the chain 194, contact with the surface of the shaft 3, whereby the chain 194 is prevented from directly contacting with the shaft 3. The rolling element 195 is a cylindrical or semispherical body having a greater diameter than the thickness of the chain 194 so that the chain 194 does not come into contact with the shaft 3. At the time of attaching the rolling elements 195 to the chain 194, the rolling elements 195 may be attached on both sides of the chain 194 at each joint of the chain 194. In this case, even if the chain 194 is bent at a joint, the chain 194 never comes into contact with the shaft 3, but the spherical surfaces of the rolling elements 195 come into contact with the shaft 3. Meanwhile, as the number of the rolling elements 195 increases, the weight increases, and therefore, adjustment may be performed so that the rolling elements 195 are attached on one side of the chain 194 at each joint or the attachment intervals of the rolling elements 195 are expanded to such an extent that the chain 194 does not contact with the shaft 3, for example.

As described above, according to embodiment 2, the effects of embodiment 1 are provided. Further, each rotation prevention fastening member 19 is provided with the rolling elements 195 at joints of the chain 194. Therefore, when the rotation prevention fastening member 19 is wound around the rotor retaining ring 2, the chain 194 does not directly contact with the rotor retaining ring 2, and instead, the rolling elements 195 contact with the rotor retaining ring 2. Thus, a frictional force applied to the rotor retaining ring 2 can be reduced, so that an effect of reducing damage to the rotor retaining ring 2 is provided. When the base unit 10 moves in the circumferential direction, the chain 194 of the rotation prevention fastening member 19 moves while sliding on the surface of the rotor retaining ring 2. Then, since the rolling elements 195 are provided, the rolling elements 195, instead of the chain 194, move while rolling on the surface of the rotor retaining ring 2. Therefore, a generated resistance force is a rolling friction on the shaft by the rolling elements 195, so that an effect of extremely reducing the resistance force and making operation of the base unit 10 smooth is provided.

### Embodiment 3

Hereinafter, an inspection device for a rotary electric machine according to embodiment 3 will be described with reference to the drawings.

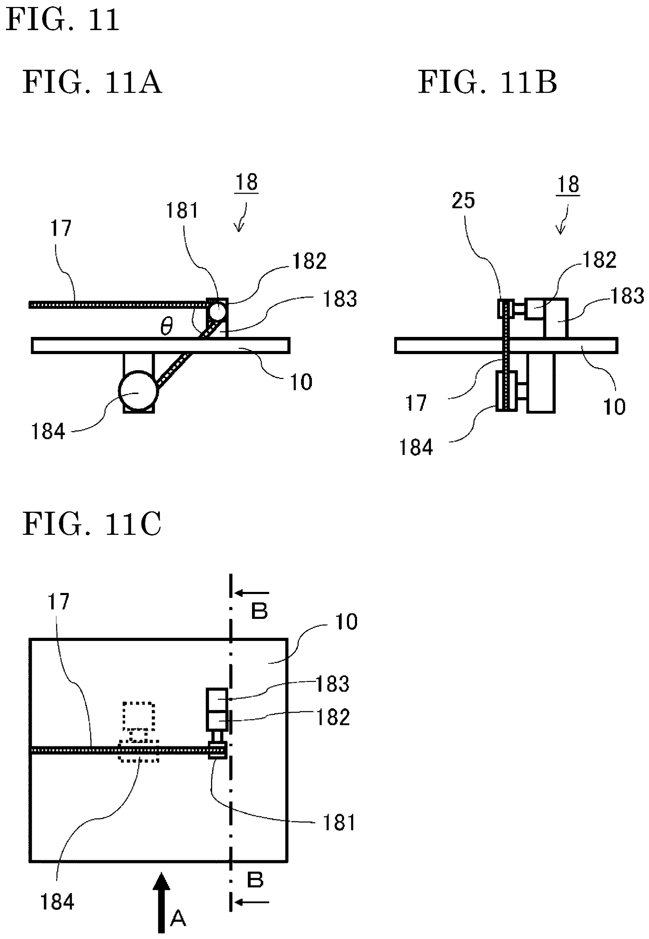

FIG. 11 shows a configuration of the driving unit 18 included in the inspection device 50 for the rotary electric machine according to embodiment 3. FIG. 11A is a view as seen from the side surface side of the rotary electric machine and from an arrow A direction in FIG. 11C, FIG. 11B is a view as seen in an arrow B-B direction in FIG. 11C, and FIG. 11C is a plan view, while components other than the driving units 18 are not shown.

### <Configuration of driving unit 18>

The driving unit 18 includes a gear 181, a rotation meter 182, a position adjustment mechanism 183, and a winding winch 184. The driving unit 18 is provided at the base unit 10 and winds and feeds the driving wire 17. Here, the driving wire 17 is a toothed wire.

The gear 181 has teeth to be meshed with the teeth of the driving wire 17, and rotates in accordance with the winding amount or the feeding amount of the driving wire 17, thus serving to replace the winding amount and the feeding amount of the driving wire 17 with a rotation amount. In addition, since the gear 181 feeds the driving wire 17, the gear 181 serves to determine the position of the driving wire 17 by the position of the gear 181 being determined. The position of the gear 181 can be adjusted by the position adjustment mechanism 183.

The rotation meter 182 has a function of reading the rotation amount of the gear 181, and the position of the rotation meter 182 can be adjusted by the position adjustment mechanism 183. Since the relative positions between the rotation meter 182 and the gear 181 do not change, the position of the driving wire 17 can be adjusted through adjustment of the position of the rotation meter 182.

The winding winch 184 includes a rotational driving source such as a motor and a rotation meter for measuring the rotation amount (not shown), and has functions of winding and feeding the driving wire 17. By adjusting the winding amount, a tension and a movement amount of the driving wire 17 are adjusted. In order to strongly mesh the teeth of the driving wire 17 and the teeth of the gear 181 with each other so that phase deviation does not occur due to step-out when they are meshed, the winding winch 184 is placed at such a position that an angle θ between parts of the driving wire 17 before and after the driving wire 17 is folded at the gear 181 becomes a right angle or an acute angle. In FIG. 11, the angle θ between parts of the driving wire 17 before and after the driving wire 17 is folded at the gear 181 is an acute angle, and the winding winch 184 is provided at a surface on a side opposite to the surface of the base unit 10 at which the gear 181, the rotation meter 182, and the position adjustment mechanism 183 are provided. Through an opening provided in the base unit 10, the driving wire 17 is wound and fed by the winding winch 184 provided at the surface on the opposite side of the base unit 10.

In a case where the winding winch 184 is placed at such a position that the angle between parts of the driving wire 17 before and after the driving wire 17 is folded at the gear 181 becomes an obtuse angle, it is desirable that a mechanism for preventing step-out of the teeth of the driving wire 17 is provided near the gear 181.

The driving wire 17 is a string-shaped or belt-shaped member that has teeth to be meshed with the gear 181, and without limitation to a wire, a cable, a rope, a belt, or the like may be employed. The driving wire 17 is a member having sufficient durability against an applied tension, and may be made of metal, resin, rubber, wool, or the like. The tooth part of the driving wire 17 is configured to have teeth at regular intervals with respect to the length of the wire so that the movement amount of the wire can be recognized from the number of the teeth. For example, teeth may be helically arranged around the wire as a core, or teeth may be formed directly on the wire.

In a case of employing a toothless driving wire, a rotary body to contact with the toothless driving wire is employed instead of a gear, and the toothless driving wire and the rotary body need to be rotated while being synchronized by means of a frictional force, an adhesion force, or the like. In this case, there is a possibility that slip occurs between the toothless driving wire and the rotary body, so that phase deviation irregularly occurs therebetween. Therefore, in order to accurately measure the movement amount of the driving wire, the driving unit 18 of the present embodiment 3 is useful. However, if there is a mechanism that can perfectly synchronize the toothless driving wire and the rotary body by a sufficient frictional force, a sufficient adhesion force, or the like without occurrence of slip, such a mechanism may be employed.

Next, effects of the driving unit 18 according to embodiment 3 will be described.

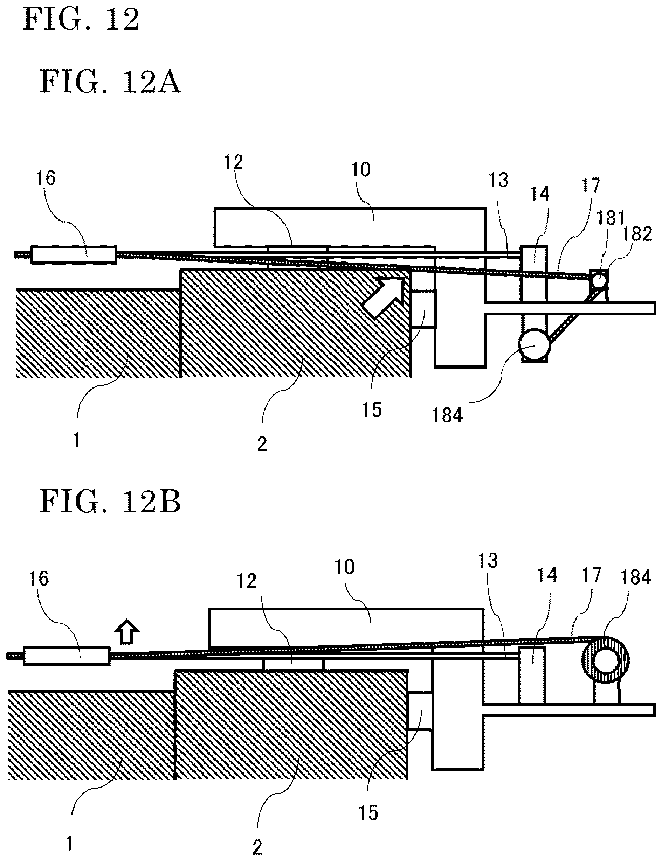

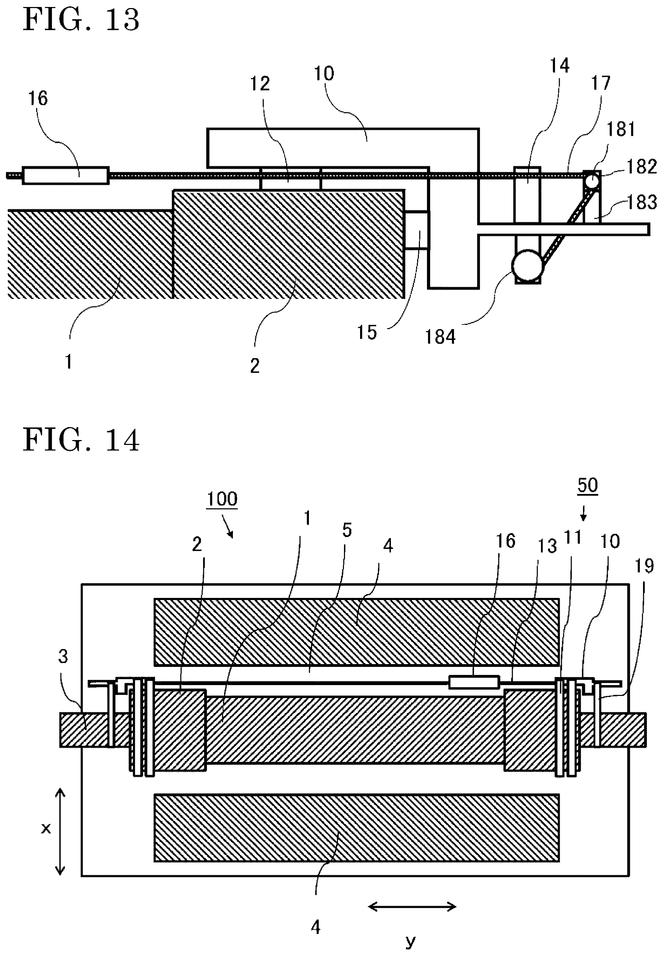

FIG. 12 shows comparative examples, where FIG. 12A shows an operation example in a case where the driving unit 18 does not include the position adjustment mechanism 183, and FIG. 12B shows an operation example of the driving unit 18 configured to drive the driving wire 17 directly by the winding winch 184. FIG. 13 shows an operation example of the driving unit 18 according to the present embodiment 3.

In FIG. 12A, when the position adjustment mechanism 183 is not provided, if the position of the driving wire 17 is close to the radius center of the rotary electric machine, the end of the rotor retaining ring 2 and the driving wire 17 contact with each other as indicated by an arrow in FIG. 12A. Further, in this state, when a tension is applied to the driving wire 17, the direction of guiding by the two guide wires 13 and the driving direction of the inspection robot 16 do not coincide with each other and therefore a force in the radial direction is applied to the inspection robot 16, so that the posture of the inspection robot 16 changes. At the same time, a force in the axial direction applied to the inspection robot 16 is reduced and therefore the inspection robot 16 cannot be driven at a desired force. Occurrence of such a problem leads to reduction in inspection accuracy of the inspection robot.

In FIG. 12B, the winding winch 184 is used with its height initially set so that the direction in which the driving wire 17 is pulled when being wound coincides with the direction of guiding by the two guide wires 13. However, as winding is advanced, the distance in the radial direction of the driving wire 17 increases, so that the direction of guiding by the two guide wires 13 and the driving direction of the inspection robot 16 do not coincide with each other as indicated by an arrow in FIG. 12B. Thus, a force in the radial direction is applied to the inspection robot 16, so that the posture of the inspection robot 16 changes. Therefore, as in the case of FIG. 12A, inspection accuracy of the inspection robot might be reduced.

On the other hand, in FIG. 13, the positions of the rotation meter 182 and the gear 181 are adjusted by the position adjustment mechanism 183, whereby the position of the driving wire 17 can be adjusted and maintained in the direction of guiding by the two guide wires 13. Therefore, the end of the rotor retaining ring 2 and the driving wire 17 do not contact with each other and a force in a direction different from the guiding direction is not applied to the inspection robot 16. Thus, the inspection device 50 can be operated stably.

As described above, according to embodiment 3, the effects of embodiment 1 are provided. Further, the driving wire 17 is a toothed wire, and the driving unit 18 which applies a tension to the driving wire 17 includes the gear 181 which rotates while being meshed with the teeth of the driving wire 17, the rotation meter 182 which measures the rotation amount of the gear, the position adjustment mechanism 183 which adjusts the positions of the gear 181 and the rotation meter 182, and the winding winch 184 which winds and feeds the driving wire 17. Therefore, the driving wire 17 and the gear 181 can be meshed with each other without phase deviation therebetween, and the winding amount and the feeding amount of the driving wire 17 can be accurately read through reading of the rotation amount of the gear 181 by the rotation meter 182. Thus, it becomes possible to accurately measure the movement amount of the inspection robot 16, whereby the inspection robot 16 can be accurately moved to an inspection target position.

Further, the position of the driving wire 17 is adjusted by the position adjustment mechanism 183, thus providing an effect that the driving wire 17 can be prevented from contacting with the end of the rotor retaining ring 2 or the like and a force in a direction different from the direction of restriction by the guide wires can be prevented from being applied to the inspection robot 16.

### Embodiment 4

In the above embodiments, the example in which the inspection device 50 inspects the cylindrical rotor 1 as the rotary electric machine 100 with the base unit 10 attached to the rotor retaining ring 2 of the rotor 1, has been described. However, the present disclosure is not limited thereto. FIG. 14 shows an example in which the inspection device is placed in a gap between a stator and a rotor of a rotary electric machine. Thus, in a state in which the rotor 1 is rotatably provided on the inner circumferential surface side of a cylindrical stator 4 with a gap 5 therebetween, i.e., the stator 4 and the rotor 1 of the rotary electric machine 100 remain combined, the inspection device 50 may be inserted into the gap 5 between the stator 4 and the rotor 1 of the rotary electric machine 100. In addition, it is also possible to inspect the stator 4 by setting the inspection target of an inspection probe (not shown) of the inspection device 50 to the outer side.

Further, such an inspection device 50 is for inspecting an inspection target part of the rotary electric machine 100 through remote operation. Therefore, as a matter of course, the inspection device 50 has dimensions and a configuration set so that the inspection device 50 can be placed in the gap 5 between the stator 4 and the rotor 1 of the rotary electric machine 100.

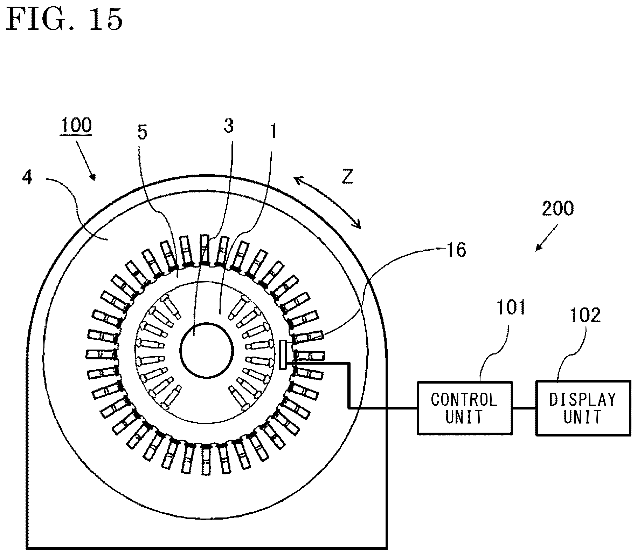

FIG. 15 shows a configuration example of an inspection system for a rotary electric machine according to embodiment 4, and the inspection system for the rotary electric machine is provided with the inspection device according to any of embodiments 1 to 3. In FIG. 15, an inspection system 200 includes the inspection device 50, a control unit 101 which controls movement in the circumferential direction z of the inspection device 50 and movements in the radial direction x and the axial direction y of the inspection robot 16, and a display unit 102 which displays the condition of the inspection device 50. The control unit 101 performs control for the position adjustment mechanism 183 of the driving unit 18, and the like. Therefore, the inspection device 50 is provided with a sensor or the like for detecting the position of the driving wire 17, and the detection information is transmitted to the control unit 101.

The inspection device 50 is connected to the control unit 101 and the display unit 102 via a cable. The control unit 101 remotely controls the inspection device 50, and may be provided with a user interface such as a keyboard, a mouse, a touch panel, and a stick for receiving an input from the outside. If all of the inspection device 50, the control unit 101, and the display unit 102 have power supplies and are configured to communicate signals wirelessly, a cable can be omitted.

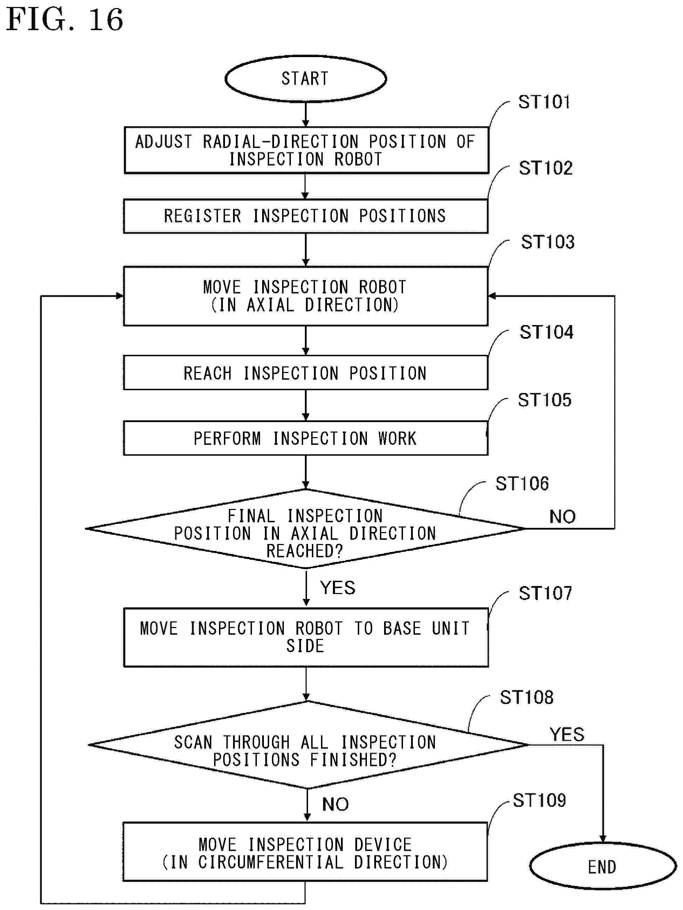

Next, with reference to FIG. 16, an inspection method for a rotary electric machine by the inspection system 200 for the rotary electric machine will be described.

First, the inspection device 50 is inserted into the gap 5 between the stator 4 and the rotor 1 inside the rotary electric machine 100. In an initial state of the inspection system 200 for the rotary electric machine, the base units 10 are provided at the rotor retaining rings 2 and the shaft 3 of the rotary electric machine 100, the guide wires 13 and the driving wire 17 are stretched through the gap 5 between the stator 4 and the rotor 1 inside the rotary electric machine 100, and the inspection device 50 is located close to one of the base units 10 in a state of being combined with the guide wires 13 and the driving wire 17.

Before the start of inspection work, the guide wire tension generation devices 14 and the position adjustment mechanisms 183 of the driving units 18 are controlled in accordance with the size of the gap 5 between the stator 4 and the rotor 1 of the rotary electric machine 100, to adjust the positions in the radial direction x of the guide wires 13 and the driving wire 17 (step ST101). Thus, the position in the radial direction x of the inspection robot 16 of the inspection device 50 placed in the rotary electric machine 100 is adjusted.

Next, positions inside the rotary electric machine 100, corresponding to an inspection target part, are registered as inspection position information in advance (step ST102).

Next, the driving units 18 are operated by the control unit 101, and in a state in which the inspection robot 16 is restricted in the circumferential direction and the radial direction by the guide wires 13, the inspection robot 16 is moved along the axial direction of the rotor 1 to the inspection position that is a start point of inspection, by the driving wire 17 (step ST103). At this time, the driving units 18 are operated while the position adjustment mechanisms 183 of the driving units 18 are controlled so that the driving wire 17 coincides with the guiding direction in the axial direction of the guide wires 13.

When the inspection robot 16 has reached the inspection position, the driving wire 17 is stopped by the driving units 18, to stop the inspection robot 16 (step ST104).

At the position where the inspection robot 16 is stopped, an inspection probe is operated to perform inspection work (step ST105). Specifically, inspection is performed through remote control in accordance with a control signal transmitted from the control unit 101 provided outside the rotary electric machine 100. Inspection is performed while the inspection robot 16 is moved along the axial direction of the rotor 1 by the driving wire 17.

Whether or not the present position is a final registered inspection position in the axial direction is determined (step ST106). If the present position is the final registered inspection position in the axial direction (YES in step ST106), the inspection robot 16 is moved to the closer one of the base units 10 (step ST107).

If the present position is not the final registered inspection position in the axial direction (NO in step ST106), the inspection robot 16 is moved toward the next inspection position by the driving wire 17 (step ST103).

If scan through all the inspection positions registered in advance is finished (YES in step ST108), the inspection flow ends.

On the other hand, if scan through all the inspection positions inside the rotary electric machine 100 has not finished, the circumferential-direction rotation wheels 12 are driven by the control unit 101, so that the inspection device 50 moves in the circumferential direction and the inspection robot 16 continues inspection (step ST109). When the inspection device 50 is moved in the circumferential direction, step ST101 may be executed to adjust the position in the radial direction x of the inspection robot 16.

While the inspection robot 16 is moving in the rotary electric machine 100, the position adjustment mechanisms 183 of the driving units 18 are controlled by the control unit 101, whereby the posture of the inspection robot 16 can be stabilized and maintained.

In step ST109, the fastening members 11 and the rotation prevention fastening members 19 are in such a fastened state that allows the inspection device 50 to move in the circumferential direction. For example, the fastening member 11 may be provided with a fastening lock and a release mechanism therefor, and fastening may be relaxed by releasing the lock, or the fastening member 11 may be formed by a slidable material. Fastening of the rotation prevention fastening member 19 may be relaxed by the tension adjustment mechanism 192.

As described above, according to embodiment 4, in an inspection process for one rotary electric machine, after the inspection device 50 for the rotary electric machine is placed inside the rotary electric machine 100, inspection work inside the rotary electric machine can be performed automatically and with high accuracy, and an effect that inspection of a rotary electric machine can be performed more efficiently is provided.

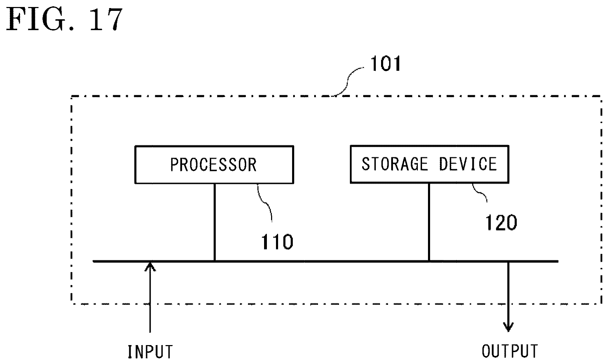

As shown in a hardware example in FIG. 17, the control unit 101 is composed of a processor 110 and a storage device 120. Although not shown, the storage device is provided with a volatile storage device such as a random access memory, and a nonvolatile auxiliary storage device such as a flash memory. Instead of a flash memory, an auxiliary storage device of a hard disk may be provided. The processor 110 executes a program inputted from the storage device 120. In this case, the program is inputted from the auxiliary storage device to the processor 110 via the volatile storage device. The processor 110 may output data such as a calculation result to the volatile storage device of the storage device 120, or may store such data into the auxiliary storage device via the volatile storage device.

In the above embodiments 1 to 4, the inspection robot 16 provided to the inspection device 50 has, for example, an ultrasonic probe, as an inspection probe, and inspects a wedge or the like of the rotor 1 by ultrasonic testing. Without limitation thereto, the inspection robot 16 may have an inspection probe based on another method such as a method using a reaction force of deformation of an inspection target surface.

Although the disclosure is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

- 1: rotor
- 2: rotor retaining ring
- 3: shaft
- 4: stator
- 5: gap
- 10: base unit
- 11: fastening member
- 12: circumferential-direction rotation wheel
- 13: guide wire
- 14: guide wire tension generation device
- 15: contact wheel
- 16: inspection robot
- 17: driving wire
- 18: driving unit
- 181: gear
- 182: rotation meter
- 183: position adjustment mechanism
- 184: winding winch
- 19: rotation prevention fastening member
- 191: rotation link
- 192: tension adjustment mechanism
- 193: connection member
- 194: chain
- 194a: end
- 195: rolling element
- 50: inspection device
- 100: rotary electric machine
- 101: control unit
- 102: display unit
- 110: processor
- 120: storage device
- 200: inspection system

## Claims

1. An inspection device for a rotary electric machine including a rotor provided around a shaft and rotor retaining rings fixed on both end sides in an axial direction of the rotor, the inspection device comprising:
base units respectively attached to the rotor retaining rings, using first fastening members;
guide wires stretched between the base units;
an inspection robot of which both side portions in a circumferential direction are restricted by the guide wires;
a driving wire which is attached to the inspection robot and moves the inspection robot in the axial direction; and
second fastening members provided to the base units and fixing the respective base units to the shaft on axial-direction outer sides relative to the first fastening members.

2. The inspection device for the rotary electric machine according to claim 1, wherein
each second fastening member includes
a string-shaped member to be wound around the shaft,
a tension adjustment mechanism which adjusts a tension of the string-shaped member,
a rotation link connecting the base unit and the tension adjustment mechanism, and
a connection member connecting the string-shaped member and the tension adjustment mechanism.

3. The inspection device for the rotary electric machine according to claim 2, wherein
in the second fastening member, the string-shaped member is a chain, and rolling elements are provided at joints of the chain.

4. The inspection device for the rotary electric machine according to any one of claims 1 to 3, wherein
the driving wire is a toothed wire,
the inspection device further comprises a driving unit which applies a tension to the driving wire,
the driving unit includes
a gear which rotates while being meshed with teeth of the driving wire,
a rotation meter which measures a rotation amount of the gear,
a position adjustment mechanism which adjusts positions of the gear and the rotation meter, and
a winding winch which winds and feeds the driving wire, and
a position of the driving wire is adjusted by the position adjustment mechanism.

5. The inspection device for the rotary electric machine according to any one of claims 1 to 4, further comprising:
circumferential-direction rotation wheels which are attached to the respective base units so as to contact with outer circumferences of the rotor retaining rings, and which assist movement of the inspection robot in the circumferential direction; and
contact wheels which are attached to the respective base units so as to contact with ends on axial-direction outer sides of the rotor retaining rings, and which assist movement of the inspection robot in the circumferential direction and make axial-direction positioning of the base units.

6. The inspection device for the rotary electric machine according to any one of claims 1 to 5, wherein
in the rotary electric machine, the rotor is rotatably provided on an inner circumferential side of a cylindrical stator with a gap therebetween, and
the inspection device is inserted into the gap, to inspect an inspection target part.

7. An inspection system for a rotary electric machine, comprising:
the inspection device for the rotary electric machine according to any one of claims 1 to 6; and
a control unit which controls movement of the inspection robot.

8. An inspection method for a rotary electric machine, in which inspection is performed using the inspection system for the rotary electric machine according to claim 7, the inspection method comprising:
a step of inserting the inspection device into the rotary electric machine and adjusting a position in a radial direction of the inspection robot;
an inspection position information registration step of registering inspection position information about an inspection target part to be inspected by the inspection robot inside the rotary electric machine;
a step of moving the inspection robot to a start point among the inspection positions on the basis of the registered inspection position information;
a step of moving the inspection robot in the axial direction of the rotor by the driving wire on the basis of the inspection position information;
a step of performing inspection at each of the inspection positions by the inspection robot on the basis of the inspection position information;
a step of determining whether inspection at all the inspection positions has finished, on the basis of the inspection position information; and
in a case where inspection at all the inspection positions has not finished, moving the inspection device in the circumferential direction, and then executing again the step of moving the inspection robot in the axial direction of the rotor and the step of performing inspection at each of the inspection positions by the inspection robot.
